# EUROPEAN PATENT SPECIFICATION

(11) **EP 0 401 900 B1**
(45) Date of publication and mention of the grant of the patent: **17.01.1996**
(21) Application number: 90201376.2
(22) Date of filing: 30.05.1990
(51) Int. Cl.: G06F 17/50

(54) **Ergonomic optimization method**
Verfahren zur ergonomischen Optimierung
Méthode d'optimisation ergonomique

(30) Priority: 07.06.1989 NL 8901446
(43) Date of publication of application: 12.12.1990
(73) Proprietor: Netherlands Car B.V., NL-6121 RD Born (NL)
(72) Inventor: Beimers, Hendrik Wiebe, NL-5707 RG Helmond (NL)
(74) Representative: Timmermans, Anthonius C.Th., Ir.

(56) References cited:
- SYSTEMS INTERNATIONAL, vol. VII, no. 3, March 1983, pages 34-36, GB; "Practical ergonomics"
- PROCEEDINGS OF THE HUMAN FACTORS SOCIETY-31ST ANNUAL MEETING-1987, pages 1393-1397, US; J. SNELL: "The computer-aided man-model: A safety valve in high technology"
- PROCEEDINGS OF THE HUMAN FACTORS SOCIETY-31ST ANNUAL MEETING-1987, pages 325-329, US; S.G. SCHIRO et al.: "Fitting population anthropometric data to a proportional man model with reference to prime computer's sammie program"

## Description

The invention relates to a method for simulating the ergonomic conditions to which a test subject is subjected, whereby images of various postures of parts of the test subject's body and/or part of said test, subject's environment are displayed on a display device and from populations of various types of test subjects a desired population of test subjects having mutually different dimensions is selected by a user of the method, that data of a first kind, which form a representation of the coordinates of parts of a selected test subject's body from the desired population described on the display device which are stored in a first memory device.

The invention furthermore relates to a device for carrying out a method simulating the ergonomic conditions to which a test subject is subjected, said device containing a display device for diagrammatically illustrating various postures of parts of a test subject's body and/or parts of his environment and said device contains a first memory device, in which there are stored data of a first kind, which form a representation of the coordinates of parts a selected test subject's body from the desired population.

When designing the place to work the ergonomic conditions should be taken into,account at an early stage already. Within the technical possibilities and requirements as well the legal and functional requirements the ergonomic requirements determine the design of the factory, the house and the cockpit, the cabin and the interior of aircraft, vessels and vehicles to a considerable degree. Also in the car indutry, in the (preliminary) design stage as well as in the preliminary development of the vehicle, people occupy themselves, in particular with regard to the driver in the vehicle, with the adaptation of the working environment and the working conditions to the possibilities and the limitations of people. More in particular, with this adaptation the relation between the occupants and the vehicle, expressed in terms of e.g. safety, comfort and efficiency of the operations to be carried out can be optimized. Inter alia for the car industry the ergonomic main elements, such as seats, instruments, controls and the driver's view, which are all concentrated around the driver, are of special importance.

In the past dummies were used in the ergonomic optimization of said main elements, which dummies were placed in a globally imitated arrangement of seat, dashboard, steering wheel and pedals. Measurements were carried out on this configuration, from which an optimum dimensioning and positioning of the various elements were derived. Usually also a multitude of detailed drawings in the shape of various sections were made, in order to be able to record the position of the elements, e.g. for the purpose of dimensioning the production templets, with greater accuracy. This known method is time-consuming and costly. A prototype had to be built of each new configuration, in order to test said configuration and to carry out new measurements thereon.

In a more recent past computers were used and are still being used as part of two- or three-dimensional CAD-systems. Parts of the interior, a simulation model of the human body placed in the interior, or freely selected combinations of parts of the simulation model with parts of the interior can be visualized thereby, from an angle to be selected, on a display device of the CAD-system. Measurements of length, but also measurements of volume, area and length along a curve can e.g. be carried out on details of that which is displayed on the display device, in order to have a direct quantitative indication with regard to e.g. the space available to the test subject with respect to his working environment. Building a prototype for this purpose is usually no longer necessary in such case.

Such a method or device is for example known from the article "Practicle Ergonomics in Systems International, vol. V11 no.3, March 1983, pages 34-36, GB. By using sophisticated software the new design of (for example) a car can be shown on a display device and amended where necessary. The software described in the above mentioned article makes it possible to show what the driver should see (dash-board panel, mirrors, etc.).

Although the known designing methods and designing systems are seen as powerful aids for obtaining an adequate three-dimentional understanding and for exposing ergonomic bottlenecks in the final product to be designed, long before the actual construction of a test model of said final product is realised, they have the disadvantage of not being suitable for evaluating aspects other than those connected with said classic ergonomics.

The object of the invention is to provide a method and a device for carrying out said method, making it possible, besides evaluating the known ergonomic aspects, to evaluate the ergonomics of the safety of a selected type of test subject placed on a seat in his vehicle and secured by the seat belt and, as far as the driver is concerned, surrounded by instruments and controls, in a simple but reliable manner for varying groups of test subjects.

For that purpose the method according to the invention is characterized in that data of a second kind, which form a representation of the coordinates of points of attachment in the vehicle of a single-point or multipoint safety belt are stored in a second memory device and that said data of the first and the second kind are read by a reading device connected to said memory device and let to a data processing unit connected to the reading device, in which data processing unit data of a third kind are computed on the basis of the data of the first and the second kind, said data of the third kind representing the coordinates of the safety belt extending across the selected test subject's body and which are displayed on the display device in the desired form together with the images at the same time for evaluating by the user of the method aspects connected with the safety of the selected test subject. The device according to the invention is characterized by the features as set out in the characterizing part of claim 8.

The advantage of the method according to the invention is that already at an early designing stage of a vehicle the ergonomic aspects connected with the safety can be effectively tested for varying types of test subjects. For varying types of test subjects it is possible to check in a simple manner, by means of measurements on the display device, whether the safety belt of a multipoint type to be selected for example extends within a certain limited area across the shoulder at the location of the shoulder, and for example cuts into the test subject's neck, and whether it interferes with the freedom of movement of e.g. the shoulder, the arm or the head. Furthermore it is possible to check e.g. the course of the safety belt at the location of the hips, lest it should cut into the flesh of the test subject's thigh, abdomen or side. On the basis of the information thus available from evaluation it is inter alia possible to draw conclusions with regard to the degree in which the legal requirements made in several countries, e.g. with regard to vehicles, are satisfied. Furthermore it is possible to draw conclusions from this information with regard to comfort and safety.

The method according to the invention provides the possibility to not only evaluate in a simple manner the limitations in the freedom of movement of occupants of the vehicle as a result of wearing multipoint safety belts, such as e.g. two-point, three-point or four-point belts, display said limitations and qualify them by means of measuring results, but it also provides a possibility to evaluate safety aspects for varying populations, such as e.g. Americans, Dutch people, Germans and Japanese, for men, women as well as for children of a desired length and a desired age, so that also from the images displayed it becomes clear which parts of the body or organs of the test subject will be subjected to forces caused by the safety belt in case of a crash of the vehicle.

It is moreover advantageous that for evaluating the safety aspects and for testing the degree in which the majority of the generally varying safety requirements in the various countries are satisfied, it is usually no longer necessary to design and construct a test bed and then carry out tests.

One method is according to the invention characterized in that the first memory device contains memory blocks, whereby respectively one part of the data of the first kind representing a certain part of the body is stored in a corresponding memory block and read from there.

The advantage of this method according to the invention is that separate parts of the body or details thereof can be visualized quickly in order to subject the position of the relevant part of the body to a thorough inspection. Furthermore fast manipulation of the data stored in the memory block will be possible and in general it will be possible to give the relevant part of the body a different dimension, in order to make it possible to carry out a thorough inspection of the relevant part of the body for test subjects from other populations as well.

A further method according to the invention is characterized in that a part of the body is selected, of which part of the body the corresponding memory block is read and data of a fourth kind are computed on the basis of the data of the first kind which have been read and on the basis of the coordinates of a point at which a part of the selected part of the body must reach, said data of a fourth kind representing the coordinates of the reaching part of the body.

Since said representations are to be made of very detailed parts of the body and be stored in the memory blocks a clear understanding is obtained, after the data of the fourth kind have been displayed on the display device, of the reachableness of in particular the dashboard and the controls for the test subjects secured by the seat belts. An optimal reachableness can be effected in this manner, which benefits the safety when the vehicle is used on the road. Parts of the part of the body to be selected that may be considered are inter alia reaching with the finger tips, the palm of the hand, the ball of the foot, whether or not provided with shoes having soles of a certain thickness, or for example the heel of the shoe, whereby also shoes with high heels are possible.

Said so-called reaching option will in practice often go together with the possibility to check whether something impossible is required when reaching with the part of the body, e.g. because the reaching point lies beyond the reach of the part of the body or that, on the contrary, it is located in a control or e.g. in the steering wheel.

Another further method according to the invention is characterized in that at least one joint of the reaching part of the body is selected, with which joint the change in the position of the part of the body is realised.

In practice also this option will generally go together with a check, in order to provide an indication about the circumstance whether a twist which is impossible for the joint in question is required in order to get at the reaching point. In general it will also be monitored whether a maximum twist is reached. Since a test subject's limbs, and in particular their joints, have a preferred position, an analysis of the degree of comfort or, on the contrary, the degree of loss of comfort as a result of the possibly more limited freedom of movement of the test subject secured in the safety belt can be made for each individual joint on the basis of a comparison between the actual angle of twist of the joint and a preferred area of angles of twist. In this manner an optimally balanced design selection can be made, without a test bed, for every type of safety belt and every type of test subject with regard to the positioning in the interior of the various main elements, among which the seats, the instruments, such as meters to be read and mirrors and controls and already at this very early designing stage, safety and comfort can be balanced in a highly careful and refined manner in order to eventually realise a final design of a vehicle optimized as regards safety and ergonomics.

The invention and its further advantages will be explained in more detail with reference to the drawings. In the drawings:
Figure 1 shows a block diagram in which the method according to the invention is diagrammatically explained;
Figure 2 shows an embodiment of the device according to the invention for carrying out the method such as explained in Figure 1;
Figure 3 shows a structural diagram by means of which, when the method according to the invention is used, visualized diagrammatic images can be evaluated.

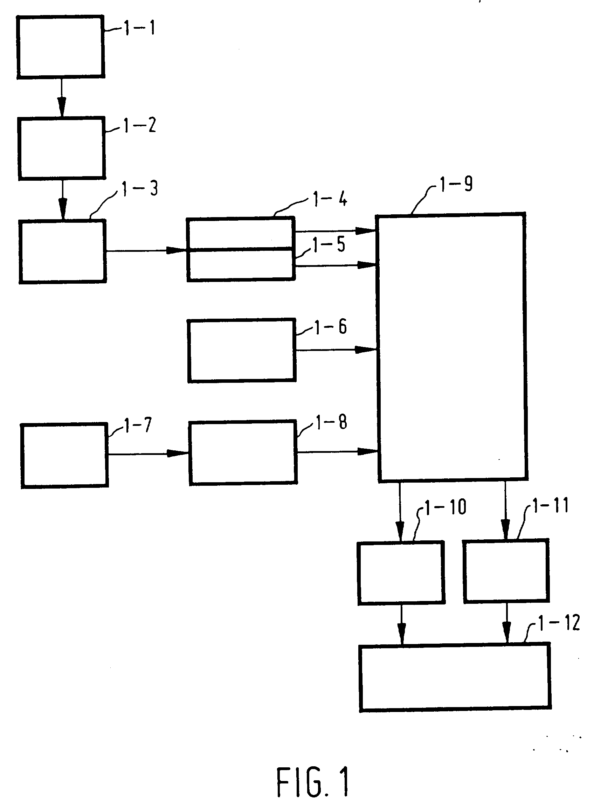

The meaning of the various blocks illustrated in Figure 1 will be explained with reference to the table hereunder.

| Block Number | Meaning of the block |
|---|---|
| 1-1 | creating populations |
| 1-2 | select a population |
| 1-3 | select a representation of a selected test subject from the population |
| 1-4 | storing data of a first kind in a first memory device |
| 1-5 | storage of data of the first kind for every part of the body in a separate memory block |
| 1-6 | provide a reaching point of a part of the body to be selected, possibly with one or more rotatable joints of said parts of the body |
| 1-7 | select the data with regard to the safety belt |
| 1-8 | storing data of a second kind in a second memory device |
| 1-9 | data for computation to data processing unit |
| 1-10 | result of the computation in the form of data of a third kind |
| 1-11 | result of the computation in the form of data of a fourth kind |
| 1-12 | data to display device |

In block 1-1 the various populations, i.e. the data of the coordinates of said populations, such as e.g. Americans, Germans, Dutch people and Japanese are created. Each of the various populations has its own particulars with regard to bulk, length, length of the various parts of the body etc. Said data can be created for populations of children of a certain age. In block 1-2 a desired population is selected from the populations created, after which in block 1-3 a representation of a selected test subject is selected from the selected population.

Selecting a test subject from a population can in practice take place in a simple manner by selection on the basis of a percentile value to be given, which percentile value forms a measure of the body length of the test subject to be selected. Said percentile value is a number, which indicates the percentage of the number of people who in this case have a body length shorter than the length of a test subject having a given percentile value. Thus the fifth percentile e.g. indicates the shortest subject but five per cent. For a test subject with a given body length and with dimensions of the parts of his body which are initially determined therewith, it is possible to determine the dimensions of said parts of the body more specifically also by means of further percentile values to be given. In that case the dimension of a relevant part of the body is therefore different from the average dimension of the part of a test subject's body within the selected population. As for body length for example a fifth percentile can be given a 95th percentile thigh length.

Possible representations of the test subject, such as they can be visualized on the display device, may have the shape of a wire model, a so-called shaded image model or a curves model, whereby the body, in particular the surface of the test subject's body, is represented by means of successive curves and ovals. The data of the first kind from block 1-3 are stored in the first memory device, as is diagrammatically illustrated in block 1-4. Possibly said storage may take place in a separate memory block of the first memory device, whereby for each part of the body the data of the first kind relating thereto are stored in the memory block in question, as explained with block 1-5. Usually the option of 1-5 goes together with the one explained in block 1-6, in which a reaching point, at which a part of the body to be selected is to reach, must be determined, possibly together with one or more rotatable joints of said part of the body. In block 1-7 the data with regard to the safety belt are more specifically determined, such as the type of safety belt, e.g. single-point, two-point, three-point or multipoint belt, the coordinates of the points of attachment of the safety belt in the vehicle are recorded and/or for example the width of the safety belt is recorded. Said data are stored in the second memory device in the form of data of the second kind, see block 1-8. The various data from the blocks 1-4, 1-5, 1-6 and/or 1-8 are combined by computation in block 1-9, after which the results are available in block 1-10, e.g. in the form of data of the third kind. Said data of the third kind represent the coordinates of the safety belt across the selected test subject's body. Said data of the third kind, on the basis of which a belt course evaluation can take place, are determined, by a computation to be further explained hereinafter, by combination of the data available in the blocks 1-4 and 1-8. In block 1-11 the data of the fourth kind are available, which data are formed, dependent on the option selected, by combination of the data from the blocks 1-4, 1-5, 1-6 and/or 1-8.

Said data of the fourth kind represent the trend of the coordinates of the reaching part of the body. In particular they represent the trend of the coordinates of the envelopment of the reaching body part, such as in the case that the curves model is visualized on the display device. In block 1-12 it is indicated that, according to which is desired, the data of the third or the fourth kind are led to the display device.

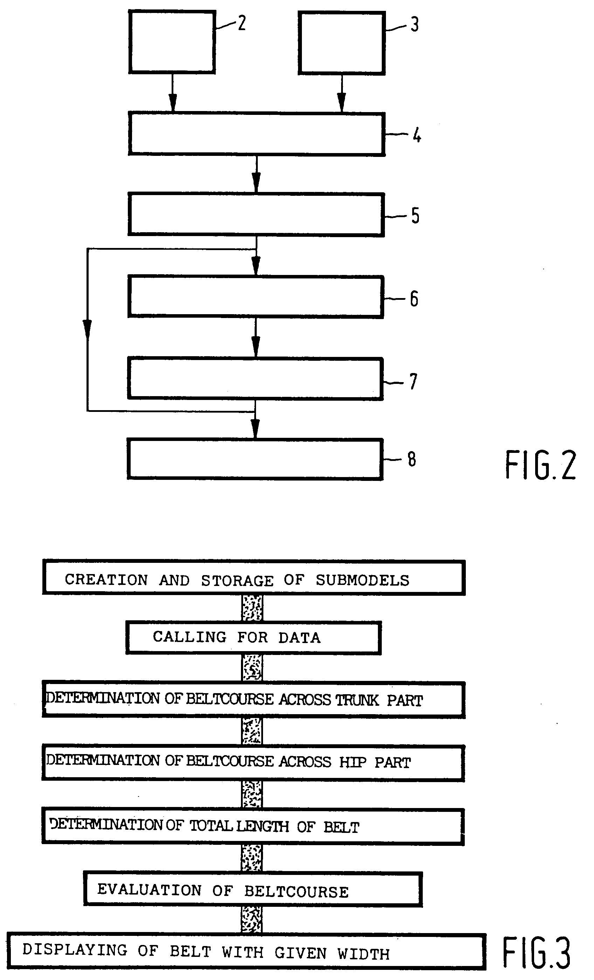

Figure 2 illustrates a possible embodiment of the device for carrying out the method, as explained with reference to Figure 1. Besides a central processing unit (not shown) and data input means for the memory devices to be mentioned hereinafter, said device contains a first memory device 2 and a second memory device 3 for storing data of the first and the second kind respectively. The two memory devices are connected, via a reading device 4, to a data processing unit 5. The data from the blocks 1-5 and 1-6 are supplied to the data processing unit 5 in a manner not shown. In said unit 5 the computation takes place, which e.g. results in the data of the third or the fourth kind.

If desired said respective data can be supplied directly to a display device 8, and be visualized thereon, but said results of the computation can also be used, via storage in a third memory device 6, for further manipulation. The data stored and manipulated in the third memory device 6 can then be read from said third memory device 6 via a further reading device 7 connected thereto, and be visualized on the display device 8 connected to said further reading device 7.

### Determination of data of the third kind for course of the belt evaluation

In a main memory of the aforesaid central processing unit there is present computer software, which groups the available data in the two memory devices 2 and 3 in several steps and which controls the computation in the data processing unit 5. The method which is used hereby will be further explained with reference to the structural diagram of Figure 3. In a first step, based on the desired evaluation of a complete model of the test subject, data of the coordinates of several submodels required are created and stored in the memory device 2, insofar as said data have not already been created and stored before. In practice it concerns the submodels of the upper and central part of the trunk of the test subject, the pelvis, the left and the right leg, the neck, the head, the left and the right upper arm and, if desired, the ends of both arms and both legs and furthermore, to a greater or lesser degree, detailed submodels of hand and feet with their respective fingers and toes, each possibly completed with their respective joints. Said data are in principle available for all populations, for every type of test subject and for every percentile value whereby, as already explained before, combinations are also possible, such as for example a Dutchman with a certain body length and a slender figure and for example short legs and large hands. Using submodels provides the system with a large degree of freedom of choice. In the structural diagram of Figure 3 said first step is indicated by "creation and storage of submodels".

Then, in a second step, the further data which are necessary for the computation are called for by said computer software. Also these data are stored in a memory which is indicated as the second memory device 3 in the embodiment already explained before. The data called for are the following:
1 dependent on the type of multipoint safety belt the coordinates of the points of attachment of the belt are called for;
2 the step size. This datum is a measure of the mutual distance of adjacent points which are located on the safety belt;
3 the belt width;
4 data are called for with regard to the manner in which the desired image must be displayed on the display device;
5 the offset. This datum is a measure of the thickness of the test subject's clothing. The thickness of the clothing can e.g. be put at 15 mm. In this datum there may furthermore be incorporated information which is a measure of how deep the safety belt cuts into the test subject's body. In that case e.g. -5 mm can be taken for this datum;
6 the location of a plane, in which the trunk part of the belt is expected to lie. Calling for this datum can e.g. take place in a manner, whereby first an estimate of the location of said plane is provided by the operator. Then said plane is displayed on the display device and the operator has a possibility to check whether the location shown corresponds with the desired location of the plane. This procedure may be repeated, if desired, until the eventual location of the plane has been determined and said location corresponds with the desired location; and
7 the location of a plane in which the hip part of the belt is expected to lie. This procedure may take place in a manner similar to the one described at 6.

In the structural diagram of Figure 3 said second step is indicated by "calling for data".

Taking e.g. a three-point belt as a starting point, in the next stage the course of the belt across the test subject's body is determined. Said determination of the course of the belt will in general take place in two steps, whereby in this case the determination of the course of the belt across the trunk part will take place in the third step, whilst in a fourth step the determination of the course of the belt across the test subject's hip part will take place.

The third step comprises the following stages:
Stage 1: The location of the plane which extends obliquely through the body, from shoulder to hip, is more specifically defined, so that said plane extends through the two attachment points of the trunk belt.
Stage 2: In this stage the intersection between said plane and the trunk parts of the body is made, resulting in the coordinates that determine the course of the belt across the body. At regularly spaced distances adjacent points of intersection are determined. Said step size is a measure of the regular distances. The points of intersection found form a first estimate for the points where the belt rests on the test subject's body.
Stage 3. A tangent to the envelopment is determined at the location of the shoulder thus found, said tangent extending through the point of attachment of the belt on the door post of the vehicle; and
Stage 4. In a similar manner a tangent to the envelopment is determined at the location of the hip, said tangent extending through the point of attachment of the belt on the tunnel or on the floor of the vehicle.

In the fourth step the determination of the course of the belt across the hip part takes place in a similar manner as described above for the third step. Said determination comprises the following stages.

Stage 1. The location at a certain angle of the plane in which the hip belt is expected to lie is determined, whilst said plane extends through the two points of attachment of the hip belt. The determination of said plane takes place insofar as it has not yet been realised in the second step.

Stage 2. Said hip belt plane is intersected with the lower part of the test subject's body, from which the points of intersection form a first estimate of the course of the belt across the test subject's body.

Stage 3. A tangent to the envelopment at the location of the hip thus formed is determined, said tangent extending through the point of attachment of the belt on the door post of the vehicle is determined; and

Stage 4. A tangent to the envelopment at the location of the hip is determined, said tangent extending through the point of attachment of the belt on the tunnel.

In the fifth step, which in the structural diagram of Figure 3 is indicated by "determining the total length of the belt", the length of the belt is computed in the following manner:
A is the uppermost point of attachment of the belt on the B-post of the vehicle;
B is the point of tangency of the trunk belt to the shoulder or the point of attachment of the frame of the chair near the centre console;
C is the point of tangency of the trunk belt on the hip near the tunnel;
D is the point of attachment of the belt on the tunnel;
E is the point of tangency of the hip belt on the hip near the tunnel;
F is the point of attachment of the hip belt on the hip near the post; and
G is the lowermost point of attachment of the belt on or near the B-post of the vehicle. The total length of the belt is determined from the sum of the lines A-B, C-D, D-E, F-G and of the curves B-C and E-F.

In the sixth step the evaluation of the course of the belt takes place, on the basis of data now available and a check for comfort and safety of the belt is carried out, on the basis of the following partial evaluations:

A Course of the belt across the shoulder.
   1 The belt is located too far away from the neck; the point A is located too much towards the shoulder;
   2 The belt cuts into the neck; the point A is located too much towards the neck;
   3 The belt leaves the body too soon; the point A is located too much forward;
   4 The belt leaves the body too late; the point A is located too much rearward/too low; and
   5 Checking the height, at which the point A is located, and possible adjustment thereof.
B Course of the belt across the trunk.
   1 Belt does not extend across the centre of the chest at a desired height;
   2 The angle at which the plane in which the trunk belt is located is inclined to the horizontal is too large or too small.
C Course of the trunk belt in the hip.
   1 The belt is located too closely under the armpit; the point D is located too high/too much inward;
   2 The belt leaves the body too soon; the point D is located too much forward;
   3 The belt leaves the body too late; the point D is located too much rearward and inward.
D Course of the hip belt in the hip.
   1 The belt is located too high above the pelvis; the point D is located too high;
   2 The belt cuts into the thigh; the point D is located too low;
   3 The belt leaves the body too soon; the point D is located too much forward;
   4 The belt leaves the body too late; the point D is located too much rearward and inward.
E Course of the hip belt in the hip.
   1 The belt is located too high above the pelvis; the point G is located too high;
   2 The belt cuts into the thigh; the point G is located too low;
   3 The belt leaves the body too soon; the point G is located too much forward;
   4 The belt leaves the body too late; the point G is located too much rearward and inward.

It will be apparent that the above partial evaluations can be adapted and completed, dependent on the specific requirements.

Finally, in the seventh step, indicated by "displaying belt with given width", the belt is visualized in whole on the display device 8.

The information thus available makes it possible to form an objective judgment about aspects of comfort and safety of the belt. Furthermore it is possible to draw conclusions from this information with regard to the degree in which the various legal requirements concerning comfort and safety are satisfied.

## Claims

1. Method for simulating the ergonomic conditions to which a test subject is subjected, whereby images of various postures of parts of the test subjects's body and/or part of said test subject's environment are displayed on a display device (8), from populations of various types of test subjects (1-1) a desired population of test subjects having mutually different dimensions is selected (1-2) by a user of the method, and data of a first kind (1-3), which form a representation of the coordinates of parts of a selected test subject's body from the desired population described on the display device are stored in a first memory device (1-4), characterized in that data of a second kind (1-7), which form a representation of the coordinates of points of attachment in the vehicle of a single-point or multipoint safety belt are stored in a second memory device (1-8) and that said data of the first and the second kind are read by a reading device connected to said memory device and led to a data processing unit (1-9) connected to the reading device, in which data processing unit data of a third kind are computed on the basis of the data of the first and the second kind, said data of the third kind representing the coordinates of the safety belt extending across the selected test subject's body and which are displayed on the display device in the desired form together with said images at the same time for evaluating by the user of the method aspects connected with the safety of the selected test subject.

2. Method according to claim 1, characterized in that said data of the third kind are stored in a third memory device connected to said data processing unit, and are led to said display device via a reading device which is on the one hand connected to said third memory device and on the other hand to said display device.

3. Method according to claim 1 or 2, characterized in that said first memory device has memory blocks, whereby respectively one part of the data of the first kind representing a certain part of the body are stored in a corresponding memory block and are read from there.

4. Method according to claim 3, characterized in that a part of the body is selected whose corresponding memory block is read and data of a fourth kind are computed, on the basis of the data of the first kind read and on the basis of the selection of the coordinates of a point at which a part to be selected of the selected part of the body is to reach, which data represent the trend of the coordinates of the reaching part of the body.

5. Method according to claim 4, characterized in that there is selected at least one joint of the reaching part of the body with which the change in the position of said part of the body is realised.

6. Method according to any one of the preceding claims, characterized in that within a selected population there is selected a test subject, on the basis of a percentile value of the body length to be given.

7. Method according to any one of the preceding claims, characterized in that the dimensions of a selected part of a selected test subject's body are determined on the basis of percentile values to be given.

8. Device for carrying out a method simulating the ergonomic conditions to which a test subject is subjected, said device containing a display device (8) for diagrammatically illustrating various postures of parts of a test subject's body and/or parts of his environment and said device contains a first memory device (2), in which there are stored data of a first kind, which form a representation of the coordinates of parts a selected test subject's body from the desired population, characterized in that said device contains a second memory device (3), in which there are stored data of a second kind, which form a representation of the coordinates of points of attachment in the vehicle of a safety belt to be selected, that said device contains a reading device (4) connected to the two memory devices for reading each of said data and that said device contains a data processing unit (5) connected to said reading device for computation, on the basis of the data of the first and the second kind, of data of a third kind representing the coordinates of the safety belt extending across the selected test subject's body and for displaying the images on the display device.

9. Device according to claim 8, characterized in that said device contains a third memory device connected to said data processing unit and a further reading device which is on the one hand connected to said third memory device and on the other hand to said display device.

## Patentansprüche

1. Verfahren zur Nachahmung der ergonomischen Bedingungen, denen eine Versuchsperson unterliegt, wobei Darstellungen unterschiedlicher Positionen von Teilen des Körpers der Versuchsperson und/oder ihrer Umgebung auf einer Anzeigevorrichtung (8) dargestellt werden, wobei von einem Anwender des Verfahrens aus Populationen unterschiedlicher Typen von Versuchspersonen (1-1) eine gewünschte Population von Versuchspersonen mit untereinander abweichenden Abmessungen gewählt wird (1-2), und wobei Daten einer ersten Art (1-3), die eine Darstellung der Koordinaten der Körperteile einer aus der gewünschten Population gewählten Versuchsperson bilden, auf der Anzeigevorrichtung in einer ersten Speichervorrichtung (1-4) abgespeichert werden, dadurch gekennzeichnet, daß Daten einer zweiten Art (1-7), die eine Darstellung der Koordinaten von Befestigungspunkten im Fahrzeug von Einpunkt- oder Mehrpunktsicherheitsgurten sind, in einer zweiten Speichervorrichtung (1-8) abgespeichert werden, und daß die Daten der ersten und der zweiten Art von einer auf die Speichervorrichtung angeschlossenen Lesevorrichtung gelesen werden und einer an die Lesevorrichtung angeschlossene Datenverarbeitungseinheit (1-9) zugeführt werden, in der auf der Grundlage der Daten der ersten und der zweiten Art Daten einer dritten Art berechnet werden, die die Koordinaten des über den Körper der gewählten Versuchsperson verlaufenden Sicherheitsgurts darstellen, welche zusammen mit den besagten Bildern in der gewünschten Form auf der Anzeigevorrichtung angezeigt werden, damit der Anwender des Verfahrens mit der Sicherheit der Versuchsperson zusammenhängende Aspekte auswerten kann.

2. Verfahren nach Anspruch 1, dadurch gekennzeichnet, daß die Daten der dritten Art in einer an die Datenverarbeitungseinheit angeschlossenen Speichervorrichtung abgespeichert werden und über eine einerseits an die dritten Speichervorrichtung und anderseits an die Anzeigevorrichtung angeschlossene weitere Lesevorrichtung der Anzeigevorrichtung zugeführt werden.

3. Verfahren nach Anspruch 1 oder 2, dadurch gekennzeichnet, daß die erste Speichervorrichtung Speicherblöcke aufweist, wobei jeweils ein, einen bestimmten Körperteil repräsentierender, Teil der Daten der ersten Art in einem entsprechenden Speicherblock abgespeichert wird und daraus gelesen wird.

4. Verfahren nach Anspruch 3, dadurch gekennzeichnet, daß ein Körperteil ausgewählt wird, dessen entsprechender Speicherblock gelesen wird und auf der Grundlage der gelesenen Daten der ersten Art und auf der Grundlage der Wahl der Koordinaten eines Punkts, zu dem ein zu wählender Teil des gewählten Körperteils hinlangen muß, Daten einer vierten Art errechnet werden, die den Verlauf der Koordinaten des hinlangenden Körperteils darstellen.

5. Verfahren nach Anspruch 4, dadurch gekennzeichnet, daß wenigstens ein Gelenk des hinlangenden Körperteils gewählt wird mit dem die Änderung der Position des Körperteils realisiert wird.

6. Verfahren nach einem oder mehreren der vorigen Ansprüche, dadurch gekennzeichnet, daß innerhalb einer gewählten Population eine Versuchsperson auf der Grundlage eines anzugebenden Prozentualwerts der Körperlänge gewählt wird.

7. Verfahren nach einem oder mehreren der vorigen Ansprüche, dadurch gekennzeichnet, daß die Abmessungen eines gewählten Körperteils einer gewählten Versuchsperson auf der Grundlage anzugebender Prozentualwerte bestimmt werden.

8. Vorrichtung zur Durchführung eines Verfahrens zur Nachahmung der ergonomischen Bedingungen, denen eine versuchsperson unterzogen wird, welche Vorrichtung eine Anzeigevorrichtung (8) zur schematischen Anzeige unterschiedlicher Positionen von Teilen des Körpers einer Versuchsperson und/oder Teile seiner Umgebung aufweist, welche Vorrichtung eine erste Speichervorrichtung (2) aufweist, in der Daten einer ersten Art abgespeichert werden müssen, die eine Repräsentation der Koordinaten der Körperteile einer aus einer gewünschten population gewählten Versuchsperson ergeben, dadurch gekennzeichnet, daß die Vorrichtung eine zweite Speichervorrichtung (3) aufweist, in der Daten einer zweiten Art abgespeichert werden, die eine Darstellung der Koordinaten von Befestigungspunkten eines zu wählenden Sicherheitsgurts in einem Fahrzeug sind, wobei die Vorrichtung eine an die beiden Speichervorrichtungen angeschlossene Lesevorrichtung (4) aufweist, um jedes der Daten zu lesen, und die Vorrichtung eine an die lesevorrichtung und die Anzeigevorrichtung angeschlossene datenverarbeitungsvorrichtung (5) aufweist, um auf der Grundlage der Daten der ersten und der zweiten Art Daten einer Dritten Art von der Datenverarbeitungsvorrichtung berechnen zu lassen, die die Koordinaten des über den Körper der gewählten Versuchsperson verlaufenden Sicherheitsgurts darstellen, und um die Bilder auf der Anzeigevorrichtung anzuzeigen.

9. Speichervorrichtung nach Anspruch 8, dadurch gekennzeichnet, daß die Vorrichtung eine an die Datenverarbeitungseinheit angeschlossene dritte Speichervorrichtung und eine einerseits an die dritte Speichervorrichtung und anderseits an die Anzeigevorrichtung angeschlossene weitere Lesevorrichtung aufweist.

## Revendications

1. Procédé pour la simulation des conditions ergonomiques auxquelles un sujet est soumis, des images de différentes positions de parties du corps du sujet et/ou de ses environs étant rendues sur un dispositif d'affichage (8), une population souhaitée composée de sujets de différentes tailles étant choisie (1-2) parmi des populations de différents types de sujets (1-1) par un utilisateur du procédé, et des données d'un premier type (1-3), qui sont une représentation des coordonnées de parties du corps d'un sujet choisi dans la population souhaitée sur le dispositif d'affichage, étant mémorisées dans un premier dispositif de mémorisation (1-4), caractérisé en ce que des donneés d'un deuxième type (1-7), qui sont une représentation des coordonnées de points de fixation d'une ceinture de sécurité à point unique ou à points multiples dans le véhicule, sont mémorisées dans un deuxième dispositif de mémorisation (1-8), et en ce que les données du premier et du deuxième type sont lues par un dispositif de lecture relié au dispositif de mémorisation et conduites à une unité de traitement de données (1-9) reliée au dispositif de lecture, dans laquelle unité de traitement de données des données d'un troisième type représentant les coordonnées de la ceinture de sécurité s'étendant sur le corps du sujet choisi sont calculées à base des données du premier et du deuxième type, lesquelles coordonnées sont visibilisées sur le dispositif d'affichage sous la forme souhaitée ensemble avec lesdites images, pour l'évaluation d'apects liés à la sécurité du sujet choisi par l'utilisateur du procédé.

2. Procédé selon la revendication 1, caractérisé en ce que les données du troisième type sont mémorisées dans un troisième dispositif de mémorisation relié à l'unité de traitement de données et qu'elles sont conduites au dispositif d'affichage par un autre dispositif de lecture relié d'une part au troisième dispositif de mémorisation et d'autre part au dispositif d'affichage.

3. Procédé selon la revendication 1 ou 2, caractérisé en ce que le premier dispositif de mémorisation comporte des blocs de mémoire, une partie des données du premier type représentant une certaine partie du corps étant mémorisée à chaque fois dans un bloc de mémoire correspondant et lue dans celui-ci.

4. Procédé selon la revendication 3, caractérisé en ce qu'on choisit une partie du corps dont le bloc de mémoire correspondant est lu, et en ce qu'à base des données lues du premier type et à base du choix des coordonnées d'un point qu'une partie à choisir de la partie choisie du corps doit atteindre, des données d'un quatrième type sont calculées, qui représentent l'évolution des coordonnées de la partie du corps devant atteindre ce point.

5. Procédé selon la revendication 4, caractérisé en ce qu'on choisit au moins une articulation du partie du corps devant atteindre ledit point avec laquelle le changement de position de la partie du corps est réalisée.

6. Procédé selon l'une quelconque des revendications précédentes, caractérisé en ce qu'on sélectionne un sujet dans une population choisie à base d'une valeur pourcentielle à donner de la taille du corps.

7. Procédé selon l'une quelconque des revendications précédentes, caractérisé en ce qu'on détermine les tailles d'une partie choisie du corps d'un sujet choisi, à base des valeurs pourcentielles à donner.

8. Dispositif pour la mise en oeuvre d'un procédé pour la simulation des conditions ergonomiques auxquelles un sujet est soumis, lequel dispositif comprend un dispositif d'affichage (8) pour la représentation schématique de différentes positions de parties du corps d'un sujet et/ou de parties de ses environs, lequel dispositif comprend un premier dispositif de mémorisation (2), dans lequel des données d'un premier type sont mémorisées, qui forment une représentation des coordonnées des parties du corps d'un sujet choisi dans une population souhaitée, caractérisé en ce que le dispositif comprend un deuxième dispositif de mémorisation (3), dans lequel des données d'un deuxième type sont mémorisées, qui sont une représentation des coordonnées de points de fixation d'une ceinture de sécurité à choisir dans un véhicule, le dispositif comprenant un dispositif de lecture (4) relié aux deux dispositifs de mémorisation pour la lecture de chacune des données, et en ce que le dispositif comprend une unité de traitement de données (5) reliée au dispositif de lecture et au dispositif d'affichage pour le calcul, par l'unité de traitement de données et à base des données du premier et du deuxième type, de données d'un troisième type qui représentent les coordonnées de la ceinture de sécurité s'étendant sur le corps du sujet choisi et pour la visibilisation des images sur le dispositif d'affichage.

9. Dispositif selon la revendication 8, caractérisé en ce qu'il comprend un troisième dispositif de mémorisation relié à l'unité de traitement de données et un autre dispositif de lecture relié d'une part au troisième dispositif de mémorisation et d'autre part au dispositif d'affichage.
